# EUROPEAN PATENT APPLICATION

(11) **EP 4 644 930 A1**
(43) Date of publication of application: **05.11.2025**
(21) Application number: 24905155.8
(22) Date of filing: 24.04.2024
(51) Int. Cl.: G01R 31/389, G01R 31/396

(54) **APPARATUS FOR TESTING OPEN CIRCUIT VOLTAGE OF BATTERY**

(30) Priority: 26.01.2024 CN 202410108715
(71) Applicant: Contemporary Amperex Technology Co., Limited, Ningde, Fujian 352100 (CN)
(72) Inventor: WU, Guixuan, Ningde, Fujian 352100 (CN); YANG, Weixu, Ningde, Fujian 352100 (CN); CAO, Wei, Ningde, Fujian 352100 (CN); ZHENG, Panze, Ningde, Fujian 352100 (CN)
(74) Representative: Gong, Jinping
(86) International application number: PCT/CN2024/089624
(87) International publication number: WO 2025/156474

(57) **Abstract**

Provided is an open circuit voltage test device for batteries, and the open circuit voltage test device for batteries includes: a conveying assembly (10); a first code scanning member (11) which is positioned above the conveying assembly (10); and a test member (14) which is arranged at the downstream of the first code scanning member (11) in a first direction, wherein a plurality of test probes (142) are arranged on the test member (14), and the space between every two adjacent test probes (142) in the first direction is adjustable. According to the device, it is only needed to drive the batteries by the conveying assembly (10) to move to realize testing, and the overall automation degree is high; moreover, the plurality of test probes (142) are arranged on the test member (14), and the space between every two adjacent test probes (142) in the first direction is adjustable, so the space between every two adjacent test probes (142) can be adjusted to make the position of each test probe (142) correspond to the position of each battery on the conveying assembly (10); and during the open circuit voltage test, a plurality of batteries on the conveying assembly (10) can be detected at a time, so the detection efficiency is obviously improved.

## Description

### TECHNICAL FIELD

The present application relates to the technical field of battery test, and particularly relates to an open circuit voltage test device for batteries. The present application claims the priority of the Chinese patent application with the application number 202410108715.2 and the title of "OPEN CIRCUIT VOLTAGE TEST DEVICE FOR BATTERY" filed by China Patent Office on January 26, 2024, the entire contents of which are incorporated herein by reference.

### BACKGROUND

An Open Circuit Voltage (OCV) test system for a battery cell is used for testing the voltage of batteries. In the process of use, the existing OCV test system for the battery cell has low degree of automation and low detection efficiency.

### SUMMARY OF THE INVENTION

In view of the above problems, the present application provides an open circuit voltage test device for batteries, aiming to solve the problems of low degree of automation and low detection efficiency of an OCV testing system for a battery cell in the process of use.

In order to solve the above technical problems, the present application provides an open circuit voltage test device for batteries, and the open circuit voltage test device for batteries includes:
a conveying assembly configured to drive the batteries to move in a first direction;
a first code scanning member which is positioned above the conveying assembly, and is configured to scan and read graphic codes on the batteries under a condition that the batteries on the conveying assembly move to be under the first code scanning member in the first direction; and
a test member which is arranged at the downstream of the first code scanning member in the first direction, in which, a plurality of test probes are arranged on the test member, and the space between every two adjacent test probes in the first direction is adjustable; and the first direction is the conveying direction of the conveying assembly.

In the technical solution of this embodiment of the present application, the batteries are placed on the conveying assembly and are driven to move in the first direction by means of the conveying assembly; after the batteries move to a first preset position, the first code scanning member will sequentially scan each battery on the conveying assembly to read information of the corresponding battery; then the conveying assembly continues to drive the batteries to move in the first direction; and after the batteries move to a second preset position, the plurality of test probes on the test member will simultaneously perform OCV testing on the plurality of batteries, and unqualified batteries can be sorted out according to the scanning result and the OCV testing result. In the technical solution, it is only needed to drive the batteries by the conveying assembly to move to realize testing, the overall automation degree is high; moreover, the plurality of test probes are arranged on the test member, and the space between every two adjacent test probes in the first direction is adjustable, so the space between every two test probes can be adjusted to make the position of each test probe correspond to the position of each battery on the conveying assembly; during the OCV testing, a plurality of batteries on the conveying assembly can be detected at one time, the detection efficiency is obviously improved; and moreover, the space between every two adjacent test probes is adjustable, so the batteries of different models can be conveniently detected, the compatibility is high, and great convenience is brought to detection personnel in use.

In some embodiments, the open circuit voltage test device for batteries further includes a first driving member, and the first driving member is arranged on the conveying assembly and is connected to the first code scanning member to drive the first code scanning member to move in the first direction. The first code scanning member is driven by the first driving member to move in the first direction so as to make the position of the first code scanning member correspond to the positions of the batteries on the conveying assembly, which facilitates the first code scanning member to scan the graphic codes on the corresponding batteries.

In some embodiments, the open circuit voltage test device for batteries further includes a tray; the conveying assembly includes a first rack and a first conveying line; the first conveying line is arranged on the first rack;
the first driving member is arranged on the first rack, the tray is arranged on the first conveying line, and the first conveying line is configured to drive the tray to move in the first direction. Therefore, the batteries can be conveniently placed on the tray and then detected.

In some embodiments, the tray includes a bottom plate and at least two clamping portions; the bottom plate is arranged on the first conveying line; and the two clamping portions are arranged on the bottom plate in the first direction at an interval, and the space between the two clamping portions is adjustable. When the plurality of batteries are placed between the two clamping portions on the bottom plate, the space between the two clamping portions can be adjusted to make the clamping portions abut against the batteries and make the batteries abut against one another, thereby stably positioning the plurality of batteries on the bottom plate and preventing the batteries on the bottom plate from shaking when the first conveying line moves.

In some embodiments, the clamping portions include clamping plates, movable plates, connecting columns, elastic members and top plates;
the clamping plates are arranged on the bottom plate in a second direction, the movable plates are located on the sides of the clamping plate facing away from the batteries, and the top plates are located on the sides of the clamping plates facing the batteries; one end of each connecting column is connected to the corresponding movable plate while the other end thereof penetrates through the corresponding clamping plate to be connected to the corresponding top plate; the connecting columns can move in the first direction relative to the clamping plates;
the elastic members sleeve the connecting columns, one end of each elastic member abuts against the corresponding clamping plate while the other end thereof abuts against the corresponding top plate, in which, the second direction is the height direction of the bottom plate, and is perpendicular to the first direction. The movable plates can be pulled with external force to drive the top plates to move by means of the connecting columns, the top plates compress the elastic members with the external force, and after the elastic members are compressed, the top plates can move towards one side of the clamping plates, and therefore the space between the two clamping portions can be adjusted.

In some embodiments, the open circuit voltage test device for batteries further includes a second rack, and the second rack is arranged on the downstream of the first rack in the first direction; and
the first conveying line on the conveying assembly is arranged on the first rack and the second rack, and the test member is arranged on the second rack. By means of the second rack, the test member can be conveniently fixed.

In some embodiments, the test member further includes a mounting base, and the mounting base is arranged on the second rack; and
a plurality of elongated holes are formed in two sides of the mounting base in the first direction, each test probe is arranged in the corresponding elongated hole, and the fixing positions of the test probes relative to the elongated holes are adjustable. Because the elongated holes are formed in the two sides of the mounting base in the first direction, and each test probe is arranged in the corresponding elongated hole, the plurality of test probes can be mounted on the mounting base together. Each test probe is fixed in the corresponding elongated hole, so the space between every two adjacent test probes can be adjusted by adjusting the positions of the test probes in the elongated holes, and then the position of each test probe corresponds to the position of each battery on the tray.

In some embodiments, the open circuit voltage test device for batteries further includes a third driving member, and the third driving member is arranged on the second rack and connected to the mounting base to drive the mounting base to move in the first direction and the second direction. When the mounting base is driven by the third driving member to move in the first direction and the second direction, the test probes on the mounting base can be synchronously driven to move in the first direction and the second direction, thus the test probes can be conveniently controlled to make contact with or be away from electrode terminals on the batteries, the degree of automation is high, and the OCV testing is conveniently carried out.

In some embodiments, the open circuit voltage test device for batteries further includes a second conveying line, the second conveying line is arranged on the second rack, and the conveying direction of the second conveying line is perpendicular to the conveying direction of the first conveying line; and
when the batteries on the tray fail to pass code scanning or testing, the second conveying line will drive the tray on the first conveying line to move. Since the conveying direction of the second conveying line is perpendicular to the conveying direction of the first conveying line, when the batteries on the tray on the first conveying line fail to pass code scanning or testing, the second conveying line will be started to transfer the tray on the first conveying line to the set position, and at this moment, to-be-detected batteries can be continuously placed on the first conveying line, thereby avoiding the interruption of the detection process, and improving the detection efficiency.

In some embodiments, the open circuit voltage test device for batteries further includes a replacement table, and the replacement table is arranged on the second rack and is configured to place the batteries on the tray on the second conveying line. When the batteries on the tray are conveyed to the set position by means of the second conveying line, the corresponding batteries can be placed on the replacement table; after the batteries failed in code scanning or testing are manually replaced, the replaced batteries can be placed on the second conveying line; and after the second conveying line moves reversely, the replaced batteries can be conveyed to the first conveying line for re-detection.

In some embodiments, the open circuit voltage test device for batteries further include a control cabinet and a plurality of indicator lamps, the control cabinet is arranged on the second rack, and the first code scanning member and the test member are electrically connected to a controller in the control cabinet respectively;
the plurality of indicator lamps are arranged on the replacement table, and each indicator lamp is electrically connected to the controller; and when the batteries on the second conveying line are placed on the replacement table, the controller will control the corresponding indicator lamps to be on. After the batteries on the second conveying line are placed on the replacement table, because the first code scanning member, the test member and the indicator lamps are electrically connected to the controller respectively, when the first code scanning member sends the code scanning result and the test member sends the testing result to the controller, the controller can control the corresponding indicator lamps to be on according to the corresponding result, thus the unqualified batteries can be quickly found according to the on-off of the indicator lamps, and can be quickly replaced.

In some embodiments, the open circuit voltage test device for batteries further includes a second code scanning member, and the second code scanning member is arranged on the second rack and is configured to scan and read the graphic codes of the replaced batteries on the second conveying line. Therefore, the graphic codes of the replaced batteries can be scanned by means of the second code scanning member, which prevents the replaced batteries from entering an OCV testing process before being scanned.

In some embodiments, the open circuit voltage test device for batteries further includes a second driving member, and the second driving member is arranged on the second rack and is connected to the second code scanning member to drive the second code scanning member to move along a first direction. The second driving member can drive the second code scanning member to move along the first direction, so that the position of the second code scanning member is conveniently adjusted to correspond to the position of the replaced battery, which facilitates the scanning of the second code scanning member.

In some embodiments, the open circuit voltage test device for batteries further includes a display, and the display is arranged on the second rack; and the first code scanning member, the second code scanning member and the test member are electrically connected to the display respectively. By means of the display, the results of the first code scanning member, the second code scanning member and the test member can be conveniently displayed, which facilitates the detection personal to check.

In some embodiments, the open circuit voltage test device for batteries further includes a fourth driving member, and the fourth driving member is arranged on the second rack and is configured to drive the movable plates to move in the first direction. Since the fourth driving member can drive the movable plates to move in the first direction, the top plates can be conveniently driven to move, thus the battery between the two top plates can be quickly released or pressed, which is conductive to the replacement of the battery.

In some embodiments, the open circuit voltage test device for batteries further includes a switch, the switch is arranged on the second rack and is electrically connected to the fourth driving member. By means of the switch, the fourth driving member can be conveniently controlled.

In some embodiments, the open circuit voltage test device for batteries further includes a storage rack for storing the replaced batteries, and the storage rack is arranged on the second rack. By means of the storage rack, the replaced batteries can be conveniently stored.

The above description is only an overview of the technical solution of the present application, and in order to be able to understand more clearly the technical means of the present application, it can be implemented in accordance with the contents of the description, and in order to make the above and other purposes, characteristics and advantages of the present application more obvious and easy to understand, the specific embodiments of the present application are listed below.

### DESCRIPTION OF THE DRAWINGS

By reading the detailed description of the preferred implementations below, various other advantages and benefits will become apparent to those of ordinary skill in the art. The drawings are for the purpose of illustrating the preferred implementations only and are not to be considered a limitation to the present application. Moreover, in all of the drawings, the same components are indicated by the same reference numerals. In the accompanying drawings:
FIG. 1 is a structural schematic diagram of an open circuit voltage test device for batteries in some embodiments of the present application;
FIG. 2 is a local structural schematic diagram of an open circuit voltage test device for batteries in some embodiments of the present application;
FIG. 3 is a local structural schematic diagram of an open circuit voltage test device for batteries in some embodiments of the present application;
FIG. 4 is a structural schematic diagram of a tray in some embodiments of the present application;
FIG. 5 is a partial enlarged schematic diagram of FIG. 4;
FIG. 6 is a structural schematic diagram of a test member in some embodiments of the present application;
FIG. 7 is a partial enlarged schematic diagram of FIG. 6;
FIG. 8 is a structural schematic diagram of a fourth driving member in some embodiments of the present application; and
FIG. 9 is a structural schematic diagram of a storage rack in some embodiments of the present application.

The attached marks and numbers in the specific embodiments are as follows:
10, conveying assembly; 101, first rack; 1011, first platform; 1012, first bracket; 102, first conveying line; 11, first scanning member; 12, first driving member; 13, tray; 131, bottom plate; 132, clamping plate; 133, movable plate; 134, connecting column; 135, elastic member; 136, top plate; 14, test member; 141, mounting base; 1411, elongated hole; 142, test probe; 15, second conveying line; 16, replacement table; 17, second scanning member; 18, second driving member; 19, second rack; 191, second platform; 192, second bracket; 20, control cabinet; 21, display; 22, storage rack; 23, third driving member; 24, indicator lamp; 25, fourth driving member; 251, cylinder; 252, fixed plate; 253, push plate; 254, moving plate; 255, guide rail; 256, slider; 257, grabber; 26, switch; and 111, battery.

### DETAILED DESCRIPTION

Embodiments of the technical solutions of the present application will be described in detail below with reference to the accompanying drawings. The following embodiments are only used to more clearly illustrate the technical solution of the present application, and therefore are only used as examples and cannot be used to limit the scope of protection of the present application.

Unless otherwise defined, all technical and scientific terms used herein have the same meanings as those commonly understood by those skilled in the art to which the present application pertains to. The terms used herein are for the purpose of describing specific embodiments only, and are not intended to limit the present application. The terms "including" and "having" and any variations thereof in the description and claims of the present application and the aforementioned description of the drawings are intended to cover non-exclusive inclusion.

In the description of the embodiments of the present application, the technical terms "first," "second," and the like are used only to distinguish between different objects, and are not to be understood as indicating or implying a relative importance or implicitly specifying the number, particular order, or primary and secondary relation of the technical features indicated. In the description of the embodiments of the present application, the meaning of "a plurality of" is two or more, unless otherwise explicitly and specifically defined.

Reference herein to "an embodiment" means that a particular feature, structure, or characteristic described in connection with the embodiment can be included in at least one embodiment of the present application. The appearance of this phrase in various places in the specification does not necessarily refer to the same embodiment, nor is it a separate or alternative embodiment that is mutually exclusive with other embodiments. It is explicitly and implicitly understood by those skilled in the art that the embodiments described herein may be combined with other embodiments.

In the description of the embodiments of the present application, the term "and/or" is simply a description of an association of associated objects, which indicates that there may exist three relationships, for example, A and/or B may represent three situations: A exists alone, both A and B exist, and B exists alone. Moreover, the character "/" herein generally indicates that the context objects are in an "or" relationship.

In the descriptions of the embodiments of the present application, the term "a plurality of" refers to more than two (including two), and similarly, "a plurality of groups" refers to more than two groups (including two groups); and "a plurality of sheets" refers to more than two sheets (including two sheets).

In the description of the embodiments of the present application, the orientation or positional relationships indicated by the technical terms "center," "longitudinal," "transverse," "length," "width," "thickness," "upper," "lower," "front," "back," "left," "right," "vertical," "horizontal," "top," "bottom," "inner," "outer," "clockwise," "counterclockwise," "axial," "radial," "circumferential," etc. are based on the orientation or positional relationships shown in the accompanying drawings, and are only for convenience of description of the present application and simplification of the description, rather than indicating or implying that the indicated device or element must have a specific orientation, be constructed and operate in a specific orientation, and therefore, cannot be understood as a limitation to the present application.

In the description of the embodiments of the present application, unless otherwise specified and limited, the technical terms "mounting," "connection," "connection" and "fixation" should be understood in a broad sense, for example, they can be fixed connection, detachable connection, or integration; or they can be mechanical connection or electrical connection; or they can be direct connection, indirect connection through an intermediate medium, or communication of the interiors of two elements or the relationship of interaction between two elements. For those of ordinary skill in the art, the specific meaning of the above terms in the present application may be understood on a case-by-case basis.

At present, in the process of cell manufacturing, in order to effectively pick out self-discharged cells which have potential safety hazards, it is needed to perform high-temperature aging on all cells, and test the voltage and internal resistance of these cells before and after aging, and then compare the data of the two tests to obtain the difference, so as to pick out the cells having the potential safety hazards, and this process is called as open circuit voltage (OCV) test for the cells. Most of existing polymer cell OCV test devices are subjected to a mode of turntable; when in use, an operator places four battery cells at a charging position on the turntable at one time, and presses a start button, the turntable will rotate to a scanning code position for code scanning on each battery cell, at this moment, the operator can place another four battery cells at the charging position on the turntable, and press the start button again, and then the battery cells subjected to code scanning will be rotated to a test position for voltage and internal resistance test; if the battery cells are tested before aging, the test data will be saved to the device; if the cells are tested after aging, the device will compare the test data with the test data before aging, then compare the obtained difference with that in a preset process requirement; if the device determines that the battery cell is unqualified, a corresponding indicator lamp at the position of the battery cell will be on, and finally the operator will manually separate the qualified product and the unqualified product. However, in the process of use, the existing OCV test device needs manual charging and discharging of materials, so the degree of automation is low, and the detection efficiency is low.

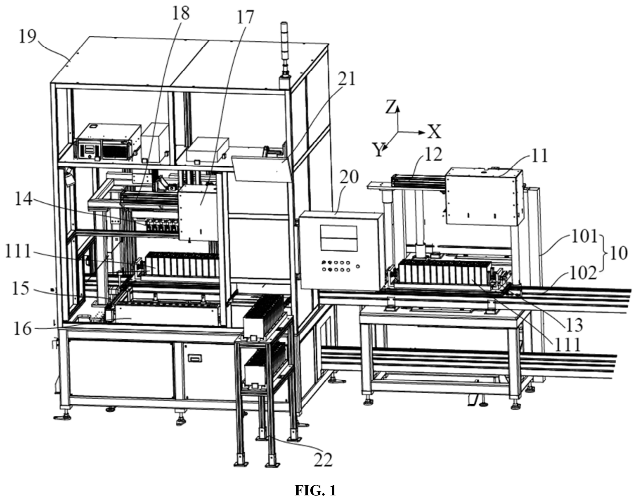

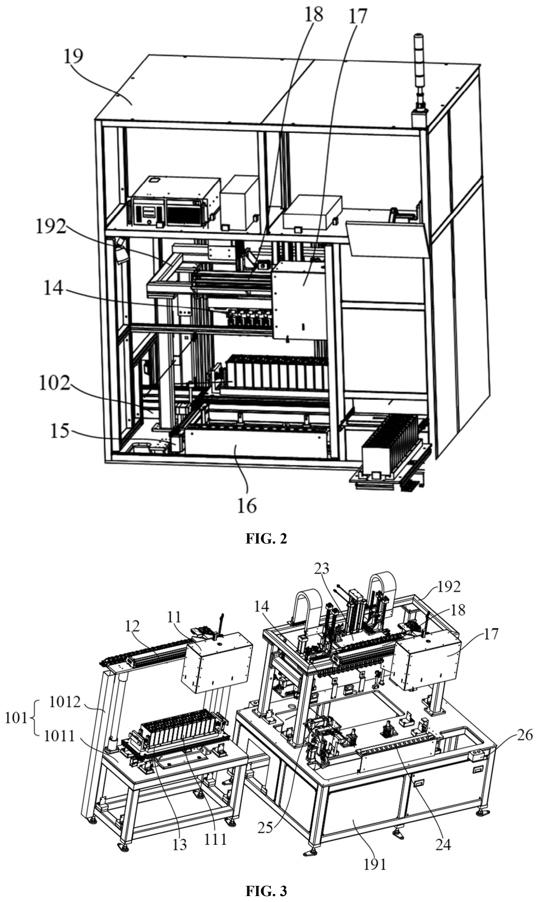

In order to solve the problems of low degree of automation and low detection efficiency in the process of use of the OCV testing device, an embodiment of the present application provides an open circuit voltage test device for batteries. As shown in FIG. 1 and FIG. 2, the open circuit voltage test device for batteries includes a conveying assembly 10, a first code scanning member 11 and a test member 14, in which, the conveying assembly 10 is configured to drive the batteries to move in a first direction; the first code scanning member 11 is positioned above the conveying assembly 10; under a condition that the batteries on the conveying assembly 10 move to be under the first code scanning member 11 in the first direction, the first code scanning member 11 will scan and read graphic codes on the batteries; the test member 14 is arranged at the downstream of the first code scanning member 11 in the first direction, a plurality of test probes 142 are arranged on the test member 14, and the space between every two adjacent test probes 142 in the first direction is adjustable; and the first direction is the conveying direction of the conveying assembly 10.

As shown in FIG. 1, in this embodiment of the description, the first direction can be an X-axis direction. The conveying assembly 10 can be of a structure of a belt conveying line, a roller conveying line and the like; and the graphic codes include a bar code, a two-dimensional code and the like, specifically, it can be determined according to actual conditions, and is not limited in this embodiment of the description.

In this embodiment, the first code scanning member 11 can be of a structure of a code scanning gun, an infrared scanner and the like. With reference to FIG. 1, when batteries 111 are placed on the conveying assembly 10, the first code scanning member 11 is located above the conveying assembly 10, and when the batteries are driven by the conveying assembly 10 to move from right to left in the X-axis direction, the first code scanning member 11 can sequentially scan the graphic code of each battery 111 on the conveying assembly 10. It is to be understood that the first code scanning member 11 can be of other structures, specifically, it can be determined according to actual conditions, and is not limited in this embodiment of the description.

In this embodiment, at least two rows of test probes 142 are arranged on the test member 14 in the X-axis direction, and the test probes 142 are battery OCV test probes. With reference to FIG. 1, the test member 14 is arranged on the left side of the first code scanning member 11, and when the batteries on the conveying assembly 10 move from right to left in the X-axis direction to be under the test member 14, the conveying assembly 10 will stop moving, and at this moment, the plurality of test probes 142 on the test member 14 will test a plurality of batteries 111 on the conveying assembly 10.

In the technical solution of this embodiment of the present application, the conveying assembly 10 is configured to drive the batteries to move along the X axis, and after the batteries move to be under the first code scanning member 11, the position of the first battery 111 in a sequence from right to left is right opposite to a scanning head on the first code scanning member 11, and the first code scanning member 11 starts to scan the battery 111 on the rightmost side of the conveying assembly 10. When the batteries are driven by the conveying assembly 10 to continue to move leftwards, the first code scanning member 11 can sequentially scan each battery 111 on the conveying assembly 10 so as to read information of the corresponding battery. After scanning is completed, the conveying assembly 10 will continue to drive the batteries 111 to move leftwards along the X axis; and when the batteries move to be under the test member 14, the conveying assembly 10 will stop moving, at this moment, the plurality of test probes 142 on the test member 14 can perform OCV testing on the batteries at the same time, and finally, the detection personnel can sort out unqualified batteries according to the scanning result and the OCV testing result.

In the technical solution, it is only needed to drive the batteries by the conveying assembly 10 to move to the positions of the first code scanning member 11 and the test member 14 to implement the battery test, the overall degree of automation is high; the plurality of test probes 142 are arranged on the test member 14, and the space between every two adjacent test probes 142 in the first direction is adjustable, so the space between every two test probes 142 can be adjusted to make the position of each test probe 142 correspond to the position of each battery on the conveying assembly 10; and in the OCV testing, the batteries on the conveying assembly 10 can be detected at a time, the detection efficiency is obviously improved; moreover, the space between every two test probes 142 is adjustable, so when detecting the batteries of different types, it is only needed to adjust the space between the test probes 142 to make sure that the space between every two adjacent test probes 142 corresponds to the position between every two adjacent batteries on the conveying assembly 10, and then the batteries of different types can be detected; and the compatibility is high, and great convenience is brought to the detection personnel in use.

According to some embodiments of the present application, as shown in FIG. 1, the open circuit voltage test device for batteries further includes a first driving member 12, and the first driving member 12 is arranged on the conveying assembly 10 and is connected to the first code scanning member 11 to drive the first code scanning member 11 to move in the first direction.

In this embodiment, the first driving member 12 can be a linear module, a cylinder, an electric telescopic rod and the like, specifically, it can be determined according to actual conditions, and is not limited in this embodiment of the description.

As shown in FIG. 1, the first driving member 12 is fixed to the conveying assembly 10 and is positioned above the conveying assembly 10, and the first code scanning member 11 is connected to the first driving member 12. When the batteries 111 are driven by the conveying assembly 10 to move to be under the first code scanning member 11, the conveying assembly 10 will stop moving, and at this moment, the first driving member 12 drives the first code scanning member 11 to move in the X-axis direction. When the scanning head on the first code scanning member 11 corresponds to the position of the graphic code on the battery 111 at the rightmost side, the first code scanning member 11 will start scanning, meanwhile, the first driving member 12 will drive the first code scanning member 11 to move leftwards at a constant speed along the X axis; and after the first code scanning member 11 scans each battery 111 on the conveying assembly 10 in a sequence from right to left, the conveying assembly 10 will continue to move.

The first driving member 12 drives the first code scanning member 11 to move along the X axis, which makes sure that the position of the first code scanning member 11 is in one-to-one correspondence with the position of each battery on the conveying assembly 10, thus facilitating the first code scanning member 11 to scan the graphic code on each battery.

According to some embodiments of the present application, as shown in FIG. 1, the open circuit voltage test device for batteries further includes a tray 13, the conveying assembly 10 includes a first rack 101 and a first conveying line 102, in which, the first conveying line 102 is arranged on the first rack 101, the first driving member 12 is arranged on the first rack 101, the tray 13 is arranged on the first conveying line 102, and the first conveying line 102 is configured to drive the tray 13 to move in the first direction.

In this embodiment, the first conveying line 102 can be a belt conveying line or a rolling conveying line, specifically, it can be determined according to actual conditions, and is not limited in this embodiment of the description.

As shown in FIG. 3, the first rack 101 includes a first platform 1011 and a first bracket 1012, in which, the first bracket 1012 is fixed to the first platform 1011, and an upper end of the first bracket 1012 is located above the first platform 1011; and the first conveying line 102 is mounted on the first platform 1011, the first driving member 12 is fixed to the upper end of the first bracket 1012, and can drive the first code scanning member 11 to move along the X axis.

When it is needed to perform detection, the to-be-detected batteries are simply placed on the tray 13 together for detection, rather than being placed on the first conveying line 102 one by one, so which facilitates detection.

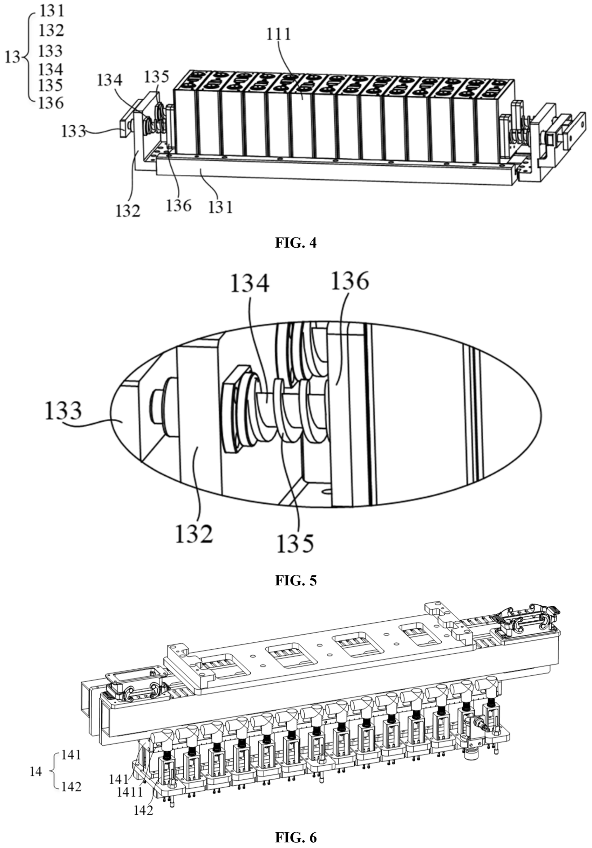

According to some embodiments of the present application, as shown in FIG. 4, the tray 13 includes a bottom plate 131 and at least two clamping portions, the bottom plate 131 is arranged on the first conveying line 102, the two clamping portions are arranged on the bottom plate 131 at an interval in the first direction, and the space between the two clamping portions is adjustable.

Exemplarily, in the present application, each of two ends of the bottom plate 131 along the X axis is provided with one clamping portion; when the plurality of batteries are placed between the two clamping portions on the bottom plate 131, the space between the two clamping portions can be adjusted to make the clamping portions abut against the batteries and make the batteries abut against one another, thereby stably positioning the plurality of batteries on the bottom plate 131, and preventing the batteries on the bottom plate 131 from shaking when the first conveying line 102 moves. It is to be understood that, in the present application, the structure that the two clamping portions are arranged on the bottom plate 131 is only an example, specifically, it can be determined according to the actual conditions, and is not limited in this embodiment of the description.

According to some embodiments of the present application, as shown in FIG. 4 and FIG. 5, the clamping portions include clamping plates 132, movable plates 133, connecting columns 134, elastic members 135 and top plates 136, in which, the clamping plates 132 are arranged on the bottom plate 131 in the second direction, the movable plates 133 are positioned on the sides of the clamping plates 132 facing away from the batteries, and the top plates 136 are positioned on the sides of the clamping plates 132 facing the batteries; one end of each connecting column 134 is connected to the corresponding movable plate 133 while the other end thereof penetrates through the corresponding clamping plate 132 to be connected to the corresponding top plate 136, and the connecting columns 134 can move relative to the clamping plates 132 in the first direction; the elastic members 135 sleeve the connecting columns 134, one end of each elastic member 135 is abutted against the corresponding clamping plate 132 while the other end thereof is abutted against the corresponding top plate 136; and the second direction is the height direction of the bottom plate 131, and is perpendicular to the first direction.

As shown in FIG. 1, in this embodiment of the description, the second direction can be a Z-axis direction. The elastic members 135 can be deformed with an external force, and restored after the external force is removed; the elastic members 135 can be elastically compressed in the X-axis direction, and can be made of a metal material or a non-metal material such as a leaf spring, a spiral spring, a gas spring and a rubber spring, specifically, it can be determined according to actual situations, and is not limited in this embodiment of the description.

In the present application, each of two ends of the bottom plate 131 in the X-axis direction is fixedly provided with one clamping plate 132; the clamping plates 132 are perpendicular to an upper surface of the bottom plate 131 along the Z axis; through holes are formed in the clamping plates 132 in the X-axis direction; one end of each connecting column 134 is in threaded connection with the corresponding movable plate 133 while the other end thereof penetrates through the corresponding through hole to be in threaded connection with the corresponding top plate 136; the connecting columns 134 are in clearance fit with the through holes; the elastic members 135 sleeve the connecting columns 134; and one end of each elastic member 135 is abutted against the corresponding clamping plate 132 while the other end thereof is abutted against the corresponding top plate 136.

In this embodiment, an initial state of the elastic members 135 mounted on the connecting columns 134 between the clamping plates 132 and the top plates 136 can be a state that the elastic members 135 are in a natural state. When a preset number of batteries 111 are placed between two top plates 136, the elastic members 135 are in a compressed state, and meanwhile, adjacent batteries 111 are sequentially abutted against each other, so that the plurality of batteries 111 can be stably positioned on the bottom plate 131.

When replacing the batteries 111 on the bottom plate 131, it is only needed to pull the movable plates 133 with external force, the movable plates 133 will drive the top plates 136 to move by means of the connecting columns 134, and then the top plates 136 compress the elastic members 135 with the external force; and after the elastic members 135 are compressed, the top plates 136 can move towards one side of the clamping plates 132, thus the space between the two top plates 136 on the bottom plate 131 can be increased, then the plurality of batteries 111 between the two top plates 136 cannot be extruded any more, the plurality of batteries 111 are relatively released, and the corresponding batteries 111 can be conveniently replaced.

It is to be noted that the structure of the clamping portions is only an example, and in other alternative solutions, other structures can be adopted, for example, the clamping portions include leaf springs and plate bodies, one end of each leaf spring is fixed to the bottom plate while the other end thereof is connected to the corresponding plate body. In the present application, the specific structure of the clamping portions are not specially limited as long as the objective of the present application can be achieved by the above connecting structures.

According to some embodiments of the present application, as shown in FIG. 1 and FIG. 2, the open circuit voltage test device for batteries further includes a second rack 19, in which, the second rack 19 is arranged at the downstream of the first rack 101 in the first direction; the first conveying line 102 on the conveying assembly 10 is arranged on the first rack 101 and the second rack 19; and the test member 14 is arranged on the second rack 19.

In this embodiment of the description, the downstream refers to the direction along the X axis, and the second rack 19 is arranged at the left side of the first rack 101.

In this embodiment, as shown in FIG. 3, the second rack 19 includes a second platform 191 and a second bracket 192, and the second bracket 192 is fixed above the second platform 191. The first conveying line 102 is arranged on the first platform 1011 on the first rack 101 and the second platform 191, as shown in FIG. 2, the test member 14 is fixed to the second bracket 192, and the test member 14 is located above the first conveying line 102. According to the present application, by means of the second bracket 192, the test member 14 can be fixed conveniently.

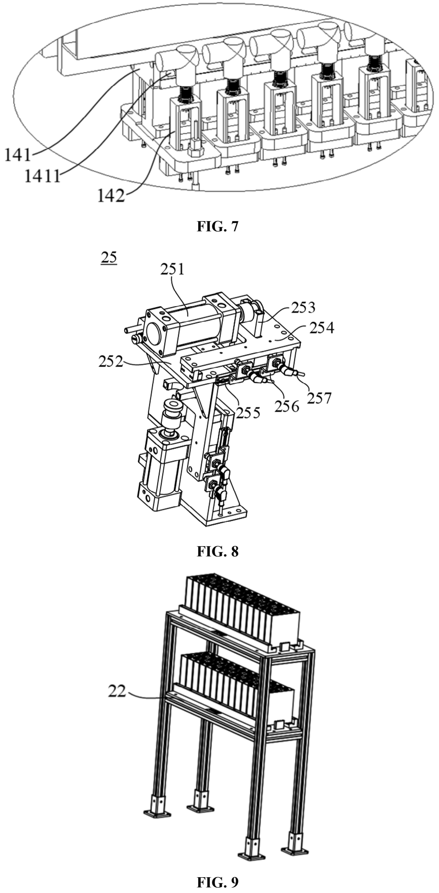

According to some embodiments of the present application, as shown in FIG. 6 and FIG. 7, the test member 14 further includes a mounting base 141, the mounting base 141 is arranged on the second rack 19, and moreover, a plurality of elongated holes 1411 are formed in two sides of the mounting base 141 in the first direction, each test probe 142 is arranged in the corresponding elongated hole 1411, and the fixed positions of the test probes 142 relative to the elongated holes 1411 are adjustable.

As shown in FIG. 7, in the present application, the plurality of elongated holes 1411 are formed in the two sides of the mounting base 141 in the X-axis direction, for example, eight or ten equal elongated holes 1411 are formed in each side, specifically, the number can be determined according to actual conditions. Upper ends of the test probes 142 are connected to bolts, and the bolts penetrate through the elongated holes 1411 and then are fixed with nuts. When it is needed to adjust the positions of the test probes 142, after the corresponding nuts are released with external force, the positions of the bolts connected to the test probes 142 are moved in the elongated holes 1411 along the X axis, and after the bolts are moved in place, the corresponding nuts can be screwed, and then the positions of the test probes 142 are adjusted.

It is to be understood that the test probes and the mounting base can be of other connecting structures, for example, the test probes are connected to the mounting base by the cylinders, specifically, it can be determined according to actual conditions, and is not limited in this embodiment of the description.

In this embodiment, the plurality of elongated holes 1411 are formed in the two sides of the mounting base 141 along the X axis, each elongated hole 1411 is correspondingly provided with one test probe 142, and therefore, the plurality of test probes 142 can be mounted on the mounting base 141 together. Each test probe 142 is fixed in the corresponding elongated hole 1411, so by adjusting the relative positions of the test probes 142 in the elongated holes 1411, the space between every two adjacent test probes 142 can be adjusted to make the position of each test probe 142 correspond to the position of each battery on the tray 13. In this way, when the plurality of batteries on the tray 13 are driven by the first conveying line 102 to move to the positions of the test probes 142, the plurality of batteries on the tray 13 can be detected at a time, and the detection efficiency is high.

According to some embodiments of the present application, as shown in FIG. 3, the open circuit voltage test device for batteries further includes a third driving member 23, and the third driving member 23 is arranged on the second rack 19 and is connected to the mounting base 141 to drive the mounting base 141 to move in the first direction and the second direction.

In this embodiment, the first direction is the X-axis direction, and the second direction is the Z-axis direction. The third driving member 23 can include two linear modules or two cylinders or two electric telescopic rods and the like, which is not limited in this embodiment of the description; and the following description is carried out by taking the third driving member 23 as two linear module.

For example, the third driving member 23 includes a first linear module and a second linear module, in which, the second linear module is fixed to a slider on the first linear module, and the mounting base 141 is fixed to a slider on the second linear module. The first linear module can drive the mounting base 141 to move in the X-axis direction by means of the second linear module, and the second linear module can drive the mounting base 141 to move in the Z-axis direction. Therefore, the test probes 142 on the mounting base 141 can be driven to move in the X-axis and the Z-axis by means of the two linear modules on the third driving member 23 respectively.

When the plurality of batteries on the tray 13 are driven by the first conveying line 102 to move to the positions of the test probes 142, the third driving member 23 will drive the test probes 142 to move along the X axis and the Z axis by means of the mounting base 141 so as to make the test probes 142 to be in contact with or away from electrode terminals on the batteries, the degree of automation is high, and the OCV testing can be conveniently performed.

According to some embodiments of the present application, as shown in FIG. 1 and FIG. 2, the open circuit voltage test device for batteries further includes a second conveying line 15, the second conveying line 15 is arranged on the second rack 19, and the conveying direction of the second conveying line 15 is perpendicular to the conveying direction of the first conveying line 102; and when the batteries on the tray 13 fail to pass code scanning or testing, the second conveying line 15 will drive the tray 13 on the first conveying line 102 to move.

In this embodiment, the conveying direction of the second conveying line 15 is a Y-axis direction, the second conveying line 15 can be a roller conveying line, specifically, it can be determined according to actual conditions. The following description is carried out by taking both the first conveying line 102 and the second conveying line 15 as the roller conveying lines.

The first conveying line 102 is provided with a plurality of first rollers that can rotate around a Y axis, meanwhile, a second roller that can rotate around the X axis is arranged between every two or three adjacent first rollers, and the second conveying line 15 is provided with a plurality of third rollers that can rotate around the X axis. With reference to FIG. 1, when the first rollers rotate, the tray on the first conveying line 102 can move along the X axis, when the second rollers rotate, the tray on the first conveying line 102 can move along the Y axis, and when the third rollers rotate, the tray on the second conveying line 15 can move along the Y axis.

During detection, when the first conveying line 102 moves normally, the first rollers rotate, the second rollers do not rotate, and at this moment, the tray 13 on the first conveying line 102 is driven by the first rollers to move in the X-axis direction.

When the batteries on the tray 13 on the first conveying line 102 fail to pass code scanning or testing, the second rollers on the first conveying line 102 rotate, the first rollers do not rotate, meanwhile, the third rollers on the second conveying line 15 rotate, and a starting end of the second conveying line 15 is tightly attached to one side of the first conveying line 102 in the Y-axis direction. Thus, when the second rollers rotate and the first rollers do not rotate, the tray 13 can move along the Y axis, and when the tray 13 is driven by the second rollers to move to be on the third rollers, the third rollers will continue to drive the tray 13 to move along the Y axis, and therefore the tray 13 on the first conveying line 102 together the batteries on the tray 13 can be transferred to be on the second conveying line 15, and at this moment, the to-be-detected batteries can continue to be placed on the first conveying line 102 again, thus avoiding interruption of the detection process, and improving the detection efficiency.

According to some embodiments of the present application, as shown in FIG. 1 or FIG. 2, the open circuit voltage test device for batteries further includes a replacement table 16, and the replacement table 16 is arranged on the second rack 19 and configured to place the batteries on the tray 13 on the second conveying line 15.

In this embodiment, the replacement table 16 can be specially configured to place the batteries on the tray 13 conveyed by the second conveying line 15. Therefore, when the batteries on the tray 13 are conveyed to the set position by the second conveying line 15, the corresponding batteries can be placed on the replacement table 16. After the batteries failed in bar scanning or testing are manually replaced, all the batteries on the replacement table 16 are transferred on the second conveying line 15, and at this moment, the second conveying line 15 moves reversely to drive the corresponding tray 13 to move reversely along the Y axis until reaching the side of the first conveying line 102 in the X-axis direction, the first rollers on the first conveying line 102 are controlled to stop rotating with reference to the description above, the second rollers on the first conveying line 102 are controlled to rotate reversely, and therefore the tray 13 on the second conveying line 15 can be transferred to the first conveying line 102. When the tray 13 moves to the middle position of the first conveying line 102 in the Y-axis direction, the second rollers will stop rotating, and at this moment, the first rollers are controlled to rotate again, and thus the replaced battery can be detected again.

According to some embodiments of the present application, as shown in FIG. 1 and FIG. 3, the open circuit voltage test device for batteries further includes a control cabinet 20 and a plurality of indicator lamps 24, in which, the control cabinet 20 is arranged on the second rack 19, and the first code scanning member 11 and the test member 14 are electrically connected to a controller in the control cabinet 20; the plurality of indicator lamps 24 are all arranged on the replacement table 16, each indicator lamp 24 is electrically connected to the controller; and when the batteries on the second conveying line 15 are transferred on the replacement table 16, the controller will control the corresponding indicator lamp 24 to be on.

Exemplarily, in this embodiment, there are ten batteries on the tray 13, the ten batteries are numbered from right to left as ①, ② ... ⑩ in turn, at the same time, the replacement table 16 is also provided with ten battery placement grooves, and the ten battery placement grooves are numbered from right to left as ① , ② ... ⑩ in turn, the ten indicator lamps 24 are numbered as ①, ② ... ⑩ in turn, in which, the ① indicator light 24 is arranged on the ① battery placement groove, and so on, the ① indicator lamp 24 is arranged on the ⑩ battery placement groove.

When the ten batteries are scanned by the first code scanning member 11, it is assumed that the code of the ⑤ battery is not clear in scanning, the use time of the ⑥ battery is overdue, and the other batteries are qualified in code scanning, the first code scanning member 11 will send the code scanning information of the ⑤ battery and the ⑥ battery to the controller.

After the ten batteries on the tray 13 are driven by first conveying line 102 to move to be under test member 14, the first conveyor line 102 will stop moving, and the ten test probes 142 on the test member 14 will carry out OCV testing on the ten batteries again; and it is assumed that the ④ battery fails to pass OCV testing, and other battery tests are qualified, the test member 14 will send the test information of the ④ battery to the controller.

Then, with reference to the description above, the tray on the first convoying line 102 together with the batteries on the tray are transferred onto the second conveyor line 15; after the tray together with the batteries on the tray are transferred to the position of the replacement table by means of the second conveyor line 15, the second conveyor line 15 will stop moving, the ten batteries on the tray are manually placed into the ten battery placement grooves in the corresponding order, and finally the controller controls the (4) indicator lamp 24, the ⑤ indicator lamp 24 and the ⑥ indicator lamp 24 to be on, so that the inspection personal can quickly find the unqualified batteries, and replace the batteries quickly.

According to some embodiments of the present application, as shown in FIG. 1 or FIG. 2, the open circuit voltage test device for batteries further includes a second code scanning member 17, and the second code scanning member 17 is arranged on the second rack 19 and configured to scan and read the graphic codes of the replaced batteries on the second conveying line 15.

In this embodiment, the structure of the second code scanning member 17 is the same as that of the first code scanning member 11, which will not be listed herein.

With reference to the above description, after the unqualified batteries are replaced, the replaced batteries will be conveyed onto the first conveying line 102 by means of the second conveying line 15, and at this moment, the second code scanning member 17 is positioned above the replaced batteries, so that the graphic codes of the replaced batteries can be conveniently scanned, and the replaced batteries are prevented from entering the OCV testing process before scanning.

According to some embodiments of the present application, as shown in FIG. 1 or FIG. 2, the open circuit voltage test device for batteries further includes a second driving member 18, and the second driving member 18 is arranged on the second rack 19 and is connected to the second code scanning member 17 to drive the second code scanning member 17 to move in the first direction.

In this embodiment, the first driving member 12 can be a linear module, a cylinder, an electric telescopic rod and the like, specifically, it can be determined according to actual conditions, and is not limited in this embodiment of the description.

With reference to FIG. 2 or FIG. 3, the second driving member 18 is fixed to the second bracket 192 on the second rack 19, the second code scanning member 17 is connected to the second driving member 18, and moreover, the second driving member 18 can drive the second code scanning member 17 to move along the X axis.

When the replaced batteries are transferred from the second conveying line 15 to the first conveying line 102, the first conveying line 102 will stop moving; and the second code scanning member 17 is located above the replaced batteries, the second driving member 18 can be controlled to drive the second code scanning member 17 to move in the X-axis direction, and therefore the position of the second code scanning member 17 can be adjusted to correspond to the position of the replaced batteries, which facilitates the scanning of the second code scanning member 17.

According to some embodiments of the present application, as shown in FIG. 1, the open circuit voltage test device for batteries further includes a display 21, the display 21 is arranged on the second rack 19; and the first code scanning member 11, the second code scanning member 17 and the test member 14 are electrically connected to the display 21.

In this embodiment, a corresponding display screen is arranged on the display 21, and therefore the detection results of the first code scanning member 11, the second code scanning member 17 and the test member 14 can be displayed through the display screen, which facilitates the detection personnel to check.

According to some embodiments of the present application, as shown in FIG. 3, the open circuit voltage test device for batteries further includes a fourth driving member 25, and the fourth driving member 25 is arranged on the second rack 19 and configured to drive the movable plates 133 to move in the first direction.

Exemplarily, as shown in FIG. 8, the fourth driving member 25 includes a cylinder 251, a fixed plate 252, a push plate 253, a moving plate 254, a guide rail 255, a slider 256 and a grabber 257, in which, the fixed plate 252 is fixed to the second platform 191, the cylinder 251 is fixed to the fixed plate 252, the fixed plate 252 is provided with the guide rail 255 along one side of the cylinder 251 in a telescopic direction, the slider 256 is slidably connected to the guide rail 255, the grabber 257 is connected to the slider 256, the slider 256 is connected to the movable plate 254, the movable plate 254 is connected to the push plate 253, and the push plate 253 is connected to a telescopic end on the cylinder 251. When in use, the push plate 253 is driven to move by means of the cylinder 251, the slider 256 is driven by the push plate 253 using the movable plate 254 to move relative to the guide rail 255, and the grabber 257 can be driven to move when the slider 256 moves. When in use, the grabber 257 is driven to move to a specified position by means of the cylinder 251, the grabber 257 is clamped to the movable plate 133, and then the grabber 257 is reversely driven by the cylinder 251 to move so as to realize the movement of the movable plate 133 along the X axis.

It is to be noted that, the structure of the fourth driving member is only an example, in other alternative solutions, other structures can also be adopted, for example, the fourth driving member is of a screw motor structure, and a screw nut on the screw motor is provided with a clamping claw. In the present application, there is no special limitation on the specific structure of the fourth driving member as long as the objective of the present application is achieved by the connecting structure.

In this embodiment, the fourth driving member 25 can drive the movable plates 133 to move along the X axis, so that the top plates 136 can be conveniently driven to move, and the battery between the two top plates 136 can be quickly released or pressed; and when the tray 13 together with the batteries on the tray 13 are moved to the replacement table 16 by means of the second conveying line 15, the second conveying line 15 will stop moving, at this moment, the top plates 136 are quickly released by the fourth driving member 25, and thus the batteries on the tray 13 can be conveniently taken down from the tray 13.

According to some embodiments of the present application, as shown in FIG. 3, the open circuit voltage test device for batteries also includes switches 26, the switches 26 are arranged on the second rack 19 and are electrically connected to the fourth driving member 25.

In this embodiment, the switches 26 are arranged on the second platform 191 on the second rack 19, and when it is needed to start or stop the fourth driving member 25, the corresponding switch 26 can be simply pressed, which facilitates the control to the fourth driving member 25.

According to some embodiments of the present application, as shown in FIG. 1 and FIG. 9, the open circuit voltage test device for batteries further includes a storage rack 22 for storing the replaced batteries, and the storage rack 22 is arranged on the second rack 19. In this embodiment, by means of the storage rack 22, the replaced batteries can be conveniently stored.

Finally, it is to be noted that the above embodiments are only used for illustrating the technical solutions of the present application, not to limit them, and although the present application is described in detail with reference to the foregoing embodiments, those of ordinary skill in the art should understand that it may still modify the technical solutions described in the foregoing embodiments, or replace some or all of the technical features therein, and these modifications or substitutions do not make the essence of the corresponding technical solutions out of the scope of the technical solutions of the embodiments of the present application, and they should be covered by the scope of the claims and description of the present application. In particular, the technical features mentioned in the various embodiments can be combined in any manner as long as there is no structural conflict. The present application is not limited to the specific embodiments disclosed herein, but rather includes all technical solutions falling within the scope of the claims.

## Claims

1. An open circuit voltage test device for batteries, comprising:
a conveying assembly (10) configured to drive the batteries to move in a first direction;
a first code scanning member (11) which is positioned above the conveying assembly (10), and is configured to scan and read graphic codes on the batteries under a condition that the batteries on the conveying assembly (10) move to be under the first code scanning member (11) in the first direction; and
a test member (14) which is arranged at the downstream of the first code scanning member (11) in the first direction, wherein a plurality of test probes (142) are arranged on the test member (14), and the space between every two adjacent test probes (142) in the first direction is adjustable; and the first direction is the conveying direction of the conveying assembly (10).

2. The open circuit voltage test device for batteries according to claim 1, further comprising a first driving member (12), wherein the first driving member (12) is arranged on the conveying assembly (10) and is connected to the first code scanning member (11) to drive the first code scanning member (11) to move in the first direction.

3. The open circuit voltage test device for batteries according to claim 2, further comprising a tray (13), wherein the conveying assembly (10) comprises a first rack (101) and a first conveying line (102); the first conveying line (102) is arranged on the first rack (101); and
the first driving member (12) is arranged on the first rack (101), the tray (13) is arranged on the first conveying line (102), and the first conveying line (102) is configured to drive the tray (13) to move in the first direction.

4. The open circuit voltage test device for batteries according to claim 3, wherein the tray (13) comprises a bottom plate (131) and at least two clamping portions; the bottom plate (131) is arranged on the first conveying line (102); and the two clamping portions are arranged on the bottom plate (131) in the first direction at an interval, and the space between the two clamping portions is adjustable.

5. The open circuit voltage test device for batteries according to claim 4, wherein the clamping portions comprise clamping plates (132), movable plates (133), connecting columns (134), elastic members (135) and top plates (136);
the clamping plates (132) are arranged on the bottom plate (131) in a second direction, the movable plates (133) are located on the sides of the clamping plates (132) facing away from the batteries, and the top plates (136) are located on the sides of the clamping plates (132) facing the batteries; one end of each connecting column (134) is connected to the corresponding movable plate (133) while the other end thereof penetrates through the corresponding clamping plate (132) to be connected to the corresponding top plate (136), and the connecting columns (134) can move in the first direction relative to the clamping plates (132); and
the elastic members (135) sleeve the connecting columns (134), one end of each elastic member (135) abuts against the corresponding clamping plate (132) while the other end thereof abuts against the corresponding top plate (136), wherein the second direction is the height direction of the bottom plate (131), and is perpendicular to the first direction.

6. The open circuit voltage test device for batteries according to claim 5, further comprising a second rack (19), wherein the second rack (19) is arranged on the downstream of the first rack (101) in the first direction; and
the first conveying line (102) is arranged on the first rack (101) and the second rack (19), and the test member (14) is arranged on the second rack (19).

7. The open circuit voltage test device for batteries according to claim 6, wherein the test member (14) further comprises a mounting base (141), and the mounting base (141) is arranged on the second rack (19);
a plurality of elongated holes (1411) are formed in two sides of the mounting base (141) in the first direction, each test probe (142) is arranged in the corresponding elongated hole (1411), and the fixing positions of the test probes (142) relative to the elongated holes (1411) are adjustable.

8. The open circuit voltage test device for batteries according to claim 7, further comprising a third driving member (23), wherein the third driving member (23) is arranged on the second rack (19) and connected to the mounting base (141) to drive the mounting base (141) to move in the first direction and the second direction.

9. The open circuit voltage test device for batteries according to any one of claims 6 to 8, further comprising a second conveying line (15), wherein the second conveying line (15) is arranged on the second rack (19), and the conveying direction of the second conveying line (15) is perpendicular to the conveying direction of the first conveying line (102); and
when the batteries on the tray (13) fail to pass code scanning or testing, the second conveying line (15) can drive the tray (13) on the first conveying line (102) to move.

10. The open circuit voltage test device for batteries according to claim 9, further comprising a replacement table (16), wherein the replacement table (16) is arranged on the second rack (19) and is configured to place the batteries on the tray (13) on the second conveying line (15).

11. The open circuit voltage test device for batteries according to claim 10, further comprising a control cabinet (20) and a plurality of indicator lamps (24), wherein the control cabinet (20) is arranged on the second rack (19), and the first code scanning member (11) and the test member (14) are electrically connected to a controller in the control cabinet (20) respectively;
the plurality of indicator lamps (24) are arranged on the replacement table (16), and each indicator lamp (24) is electrically connected to the controller; and when the batteries on the second conveying line (15) are placed on the replacement table (16), the controller can control the corresponding indicator lamps (24) to be on.

12. The open circuit voltage test device for batteries according to claim 9, further comprising a second code scanning member (17), wherein the second code scanning member (17) is arranged on the second rack (19) and is configured to scan and read the graphic codes on the replaced batteries on the second conveying line (15).

13. The open circuit voltage test device for batteries according to claim 12, further comprising a second driving member (18), wherein the second driving member (18) is arranged on the second rack (19) and is connected to the second code scanning member (17) to drive the second code scanning member (17) to move in the first direction.

14. The open circuit voltage test device for batteries according to claim 12, further comprising a display (21), wherein the display (21) is arranged on the second rack (19); and the first code scanning member (11), the second code scanning member (17) and the test member (14) are electrically connected to the display (21) respectively.

15. The open circuit voltage test device for batteries according to claim 6, further comprising a fourth driving member (25), wherein the fourth driving member (25) is arranged on the second rack (19) and is configured to drive the movable plates (133) to move in the first direction.

16. The open circuit voltage test device for batteries according to claim 15, further comprising a switch (26), wherein the switch (26) is arranged on the second rack (19) and is electrically connected to the fourth driving member (25).

17. The open circuit voltage test device for batteries according to claim 6, further comprising a storage rack (22) for storing the replaced batteries, wherein the storage rack (22) is arranged on the second rack (19).
